Europäisches Patentamt

European Patent Office

Office européen des brevets

(11) Numéro de publication : **0 006 810**
**B1**

# FASCICULE DE BREVET EUROPÉEN

(45) Date de publication du fascicule du brevet :
**19.05.82**

(21) Numéro de dépôt : **79400419.2**

(22) Date de dépôt : **25.06.79**

(51) Int. Cl.³ : **H 01 L 21/48, H 01 L 49/02,**
**H 05 K 3/36**

(54) **Procédé de fabrication d'un circuit intégré hybride.**

(30) Priorité : **29.06.78 FR 7819509**

(43) Date de publication de la demande :
**09.01.80 (Bulletin 80/01)**

(45) Mention de la délivrance du brevet :
**19.05.82 Bulletin 82/20**

(84) Etats contractants désignés :
**BE DE GB NL**

(56) Documents cités :
**DD - A - 134 471**
**FR - A1 - 2 390 006**

**SOLID-STATE TECHNOLOGY, Vol. 22, n° 1, janvier 1979, Washington, R. ALLINGTON et al. « Characterization of thick film compositions on porcelain steel substrates », pages 81 à 86**

(73) Titulaire : **L.C.C.-C.I.C.E. - COMPAGNIE EURO-PEENNE DE COMPOSANTS ELECTRONIQUES**
**36, avenue Galliéni**
**F-93170 Bagnolet (FR)**

(72) Inventeur : **Quintin, Renée LE MATERIEL TELEPHO-NIQUE**
**46-47 Quai Alphonse Le Gallo**
**F-92103 Boulogne Billancourt Cedex (FR)**
Inventeur : **Villemant, Claude Marie LE MATERIEL TELEPHONIQUE**
**46-47 Quai Alphonse Le Gallo**
**F-92103 Boulogne Billancourt Cedex (FR)**

(74) Mandataire : **Thrierr, Françoise**
**THOMSON-CSF SCPI 173, Bld Haussmann**
**F-75360 Paris Cedex 08 (FR)**

# 0 006 810

## Procédé de fabrication d'un circuit intégré hybride

La présente invention concerne un procédé de fabrication d'un circuit intégré hybride sur un support, où ce support permet la connexion à la masse de pastilles semiconductrices et l'évacuation de la chaleur dissipée par ces éléments.

Un circuit intégré hybride est constitué généralement par une association sur un support approprié d'éléments passifs, tels que résistances et condensateurs déposés en couches minces ou épaisses, et d'éléments actifs, diodes, transistors ou même de circuits intégrés monolithiques, réunis entre eux par un réseau d'interconnexion, lui-même réalisé en couches conductrices.

Le support, parfois appelé substrat, du circuit, est le plus souvent une plaquette de céramique à base d'alumine ou d'oxyde de béryllium qui sont des substances nobles et chères. La conductivité thermique de ces matériaux est faible par rapport aux métaux, mais ils ont l'avantage de résister aux hautes températures exigées par la cuisson des couches dites « épaisses ».

La sérigraphie est une bonne méthode pour appliquer ces couches à un faible prix de revient et il existe plusieurs types de pâtes commercialisées qui permettent d'envisager de nouvelles applications prometteuses.

Cependant, les plaquettes en céramique du fait de leur coût élevé, de leur fragilité, de la difficulté à les usiner et de leur conductivité thermique relativement faible, ne se prêtent pas à la réalisation de circuits à grande surface, comme les circuits imprimés sur support en matériaux stratifiés ou composites.

Par contre, ces derniers matériaux présentent le défaut majeur de ne pas supporter des températures aussi élevées que les céramiques, ce qui ne permet pas l'application et la cuisson à haute température de certaines compositions de pâtes utilisées pour la fabrication des couches « épaisses » conductrices, diélectriques ou résistives.

En vue de pallier les inconvénients antérieurs, la présente invention s'est fixée comme but la réalisation d'un circuit intégré hybride sur un support en un matériau présentant les caractéristiques suivantes :

— conductivité thermique très supérieure à celle d'une céramique en alumine ou oxyde de béryllium ;

— résistance aux températures élevées qui sont exigées pour cuire certaines pâtes appliquées par sérigraphie ;

— prix de revient à surface égale inférieur à celui des céramiques couramment utilisées ;

— plus facilement usinable que les céramiques et surtout il peut être plié, cambré, embouti et poinçonné ;

— conducteur d'électricité et métallisable par un procédé électrochimique.

Toutes ces caractéristiques offrent des avantages indiscutables vis-à-vis des supports en céramique. Elles se traduisent par la possibilité d'obtenir des circuits intégrés hybrides de performances plus élevées, présentant une surface plus importante, une plus grande souplesse d'application, ainsi qu'un prix de revient global plus faible.

Les objets et caractéristiques de la présente invention apparaîtront plus clairement à la lecture de la description suivante d'exemples de réalisation, ladite description étant faite en relation avec les dessins ci-annexés dans lesquels :

la figure 1   représente en coupe une plaque d'acier à l'état brut ;
la figure 2   représente en coupe la plaque après un traitement préparatoire de surface ;
la figure 3   représente en coupe la plaque partiellement masquée ;
la figure 4   représente en coupe la plaque après le dépôt d'une composition d'émail ;
la figure 5   représente en coupe la plaque après séchage du dépôt d'émail ;
la figure 6   représente en coupe la plaque après enlèvement partiel du dépôt d'émail ;
la figure 7   représente en coupe la plaque après cuisson du dépôt d'émail ;
la figure 8   représente en coupe la plaque après revêtement métallique de l'acier ;
la figure 9   représente en coupe la plaque émaillée recouverte d'un réseau d'interconnexion et de couches résistives et diélectriques ;
la figure 10   représente en coupe la plaque émaillée précédente où des pastilles semiconductrices sont fixées sur des surfaces métalliques ;
la figure 11   représente en coupe un circuit intégré hybride après raccordement des pastilles ;
la figure 12   représente une forme possible du support d'un circuit intégré hybride fabriqué selon le procédé conforme à l'invention.

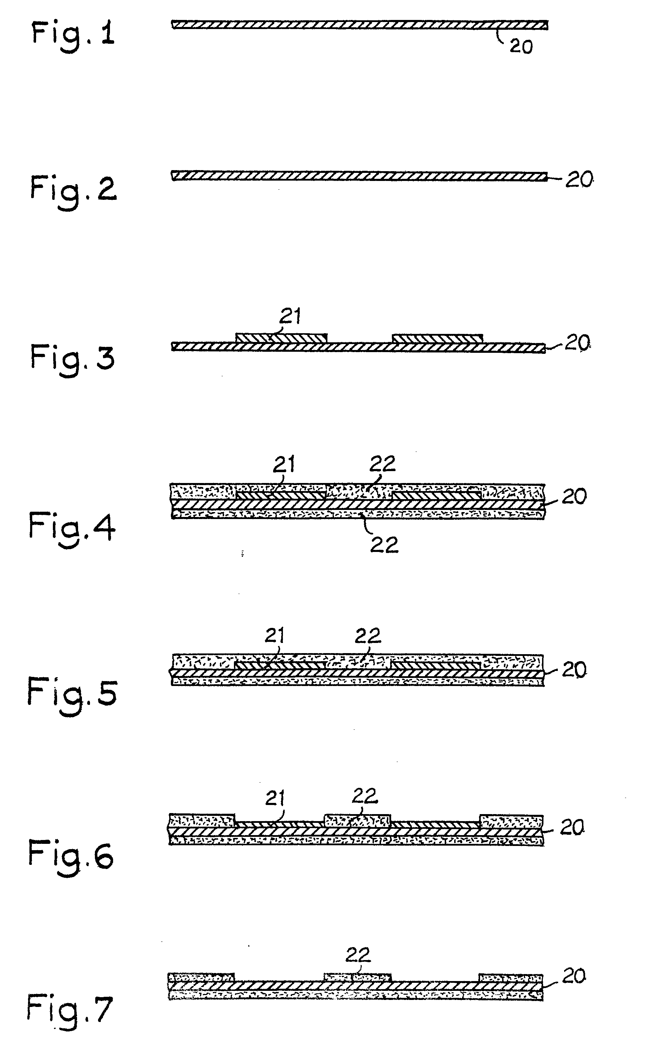

Les différentes étapes du procédé de fabrication vont être maintenant exposées à l'aide des figures 1 à 12.

On prend comme support ou substrat du circuit une plaque 20 d'acier doux, décarburé, par exemple de format rectangulaire et dont l'épaisseur est voisine de 0,8 mm. Cette plaque 20 est nettoyée selon les règles de l'art pour enlever les graisses, oxydes et saletés, puis soumise éventuellement à un traitement chimique qui rend sa surface rugueuse, par exemple un traitement d'attaque par un acide comme l'acide sulfurique.

Ce traitement préparatoire (fig. 2) a pour but de rendre les surfaces de plaque aptes à accrocher plus facilement par la suite une couche d'émail vitrifiable à chaud.

Ce traitement peut comprendre un dépôt métallique effectué chimiquement ou électrolytiquement dans des bains de sels de nickel en vue de créer une couche de nickel mince et uniforme en surface de plaque.

L'opération suivante (fig. 3) consiste à masquer complètement certaines zones de surface choisies sur un côté de la plaque ou sur les deux. Ces zones étant celles destinées ultérieurement à la fixation de certains éléments électroniques, tels que des circuits intégrés monolithiques sous forme de pastilles.

Ce masquage est effectué en appliquant localement sur chaque zone de préférence une couche 21 ou un film de « réserve », en matériaux organiques. Cette couche ou ce film doit avoir la propriété de se décomposer ou de se volatiliser complètement à une température inférieure à la température requise pour la cuisson de la composition d'émail qui sera appliquée au stade suivant.

La couche de « réserve » peut être constituée d'un matériau ou d'une composition de matériaux à base de matières plastiques ayant la propriété de se décomposer ou de se volatiliser à une température élevée. Parmi ceux-ci on peut citer les résines photopolymérisables et les vernis cellulosiques.

On peut également utiliser des caches en papier adhésif coupés aux dimensions des zones choisies ou des vernis pelables à la place des précédents matériaux.

Un autre moyen valable pour masquer les zones choisies consiste à appliquer des caches métalliques, de préférence magnétiques, sur la plaque d'acier.

Quand les zones de surface choisies sont masquées, on dépose (fig. 4) sur les zones non protégées de la plaque, c'est-à-dire nues, de la plaque, ainsi que par-dessus les couches de « réserve » ou les caches énumérés, une couche 22 d'une composition d'émail vitrifiable pour acier.

De préférence, cette composition aura une consistance liquide, ou pâteuse, ou pulvérulente, pour pouvoir être appliquée par l'une des techniques suivantes : peinture, trempé, projection, évaporation, électrophorèse, dépôt par flot ou sérigraphie.

Parmi les différentes compositions pour émaux applicables à l'acier connues antérieurement, on choisira celle qui après le stade de cuisson répondra aux impératifs suivants : la résistance mécanique et l'état de surface de l'émail vitrifié doivent garder une qualité excellente à une température voisine de 650 °C pour pouvoir appliquer et cuire ultérieurement des couches dites « épaisses » déposées sur la couche d'émail. De plus, l'émail doit posséder les caractéristiques diélectriques exigées par le circuit.

Le tableau suivant indique des compositions typiques d'émaux pouvant être appliqués dans ce cas, les deux types pouvant être éventuellement mélangés.

| | Email Type I | Email Type II |
|---|---|---|
| SiO2 | 40–50 | 30–40 |
| B2O3 | 20–25 | 20–25 |
| Alcalins fondants | 20–25 | 15–20 |
| Titane | – | 20 |
| Alumine | 3–4 | 1 |
| Oxydes d'adhérence | 15–20 | – |
| Fluor | 4 | 4 |
| Temp. de mise en oeuvre | 780°C | 840°C |
| Dilatation cubique $10^{-7}$ entre 20°C et 100°C | 280–300 | 245–255 |

Les plaques sont ensuite étuvées (fig. 5) pour chasser l'eau ou d'autres solvants contenus dans la composition d'émail. Cet étuvage doit être réalisé à une température gardant intactes les couches de

3

« réserve » ou les caches.

Avant de passer au stade de cuisson, on détache et enlève la couche d'émail (fig. 6) séchée, déposée sur la couche de « réserve », par application d'une technique, en relation avec la nature de la couche, telle que l'application de chocs, de vibrations, de soufflage, d'aspiration ou par un moyen de préhension.

La couche d'émail déposée et séchée sur la plaque rugueuse restera accrochée, tandis que celle déposée sur la couche de « réserve » se détachera et s'enlèvera d'autant plus facilement que la surface de la couche de « réserve » au contact du dépôt d'émail séché est plus lisse.

Si l'on utilise des caches métalliques à la place des couches organiques, celles-ci seront enlevées avant l'opération de cuisson de l'émail.

Après le nettoyage des couches de « réserve » ou l'enlèvement des caches, on passe au stade de cuisson de l'émail (fig. 7). Le cycle du traitement thermique appliqué doit être en rapport avec la composition de l'émail. On utilisera de préférence la plage de température de cuisson de 780° à 840 °C, ce qui est en général de règle pour les émaux utilisés couramment pour émailler les tôles d'acier et dont la composition figure dans le tableau précédent.

Ce traitement thermique terminé l'émail adhère définitivement à l'acier et forme une couche continue diélectrique. En même temps, si on a utilisé des couches de « réserve » composées de matériaux organiques, celles-ci brûleront et se volatiliseront. De cette manière, les zones métalliques masquées précédemment sont de nouveau remises à nu.

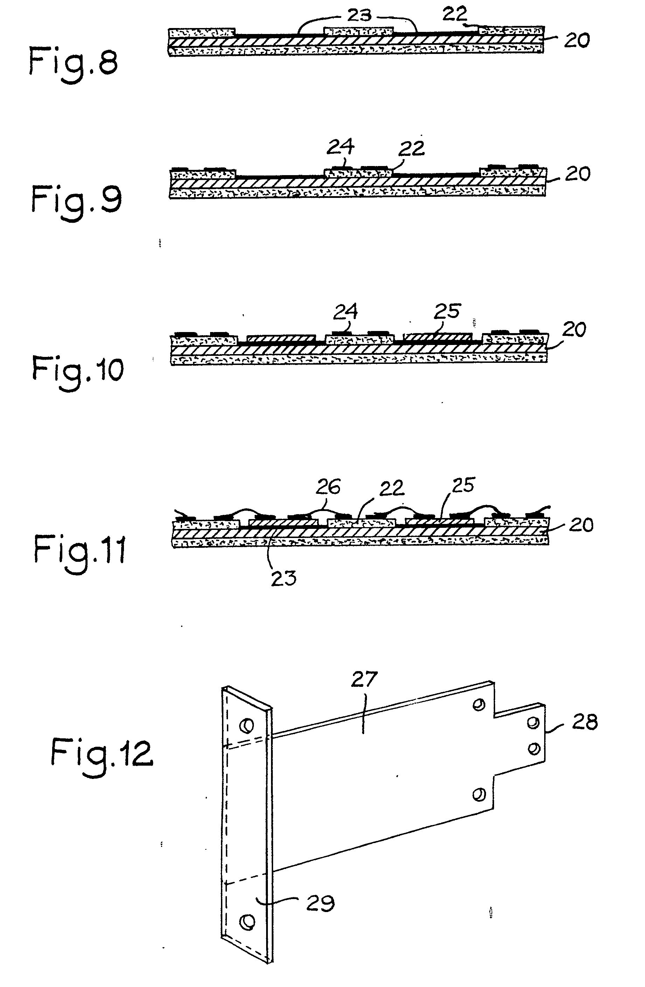

L'opération suivante (fig. 8) consiste à préparer, puis à revêtir ces zones nues d'une ou de plusieurs couches métalliques 23 bonnes conductrices d'électricité, dont la dernière couche est facilement soudable. On déposera de préférence une couche d'or, d'argent, ou d'étain-plomb sur une couche de nickel ou de cuivre. Pour déposer ces couches, on fera appel aux techniques de dépôt connues, telles que le dépôt chimique ou électrolytique, le dépôt par sérigraphie de pâtes, le dépôt par évaporation ou par projection de métaux à travers des masques.

La couche d'émail cuite est alors prête à recevoir le réseau d'interconnexion 24 du circuit intégré hybride (fig. 9). Ce réseau est réalisé selon la technique sérigraphique des couches dites « épaisses » dans laquelle des encres ou pâtes conductrices sont appliquées sur la couche d'émail, puis cuites à une température en relation avec les compositions des pâtes ou encres utilisées. Cette technique sérigraphique est économique et, de ce fait, couramment employée pour la réalisation de couches conductrices, diélectriques et résistives sur des substrats en céramique.

Néanmoins, si l'on désire obtenir des performances électriques impossibles à obtenir par dépôt sérigraphique, on utilisera les autres techniques de dépôts bien connues telles que : dépôts par évaporation ou projection de métaux à travers des masques.

Des circuits intégrés monolithiques 25, en forme de pastille, ou « puce » peuvent ensuite être fixés (fig. 10) sur les zones nues de plaque qui ont été préalablement préparées pour être soudables. Selon l'état de surface métallique ou semiconductrice, ou présentant les deux aspects, il faudra les fixer par une technique appropriée au cas : alliage, brasage, soudage avec apport ou non d'un métal pur, ou d'un mélange eutectique placé entre la pastille et la couche soudable.

On pourra aussi utiliser la méthode qui consiste à coller les pastilles à l'aide de colles conductrices.

On remarquera que les liaisons ainsi établies entre les pastilles et le support en acier sont éminemment favorables à un excellent refroidissement des pastilles du fait que l'acier a une excellente conductivité thermique, bien meilleure que celle des céramiques, et aussi du fait de la très faible épaisseur des liaisons entre les pastilles et le support en acier.

On pourra évidemment utiliser ces zones de surface métallique de la plaque pour souder d'autres éléments électroniques, qu'ils soient actifs ou passifs, à la place des pastilles semiconductrices.

Le raccordement du réseau d'interconnexion et des pastilles semiconductrices ou des autres éléments électroniques peut se faire ensuite selon les méthodes traditionnelles à savoir : par soudage de microfils 26 ou par une autre technique de fixation définitive, soit en utilisant des micropoutres ou des microrubans.

La figure 12 représente une autre forme possible d'un support 27 d'un circuit intégré hybride conforme à l'invention. Au lieu d'une plaque 20 complètement plate, on a préféré découper celle-ci avant les opérations décrites précédemment afin de former une bande 28 plus étroite à un bout et de plier à angle droit l'autre bout pour former une aile plate 29. Cette bande 28 une fois émaillée servira comme support des terminaisons conductrices du réseau d'interconnexion et pourra être équipée d'un organe de connexion mâle, ou femelle, ou être prévue pour un enfichage direct dans un connecteur femelle. L'aile 29, plate, pourra par exemple être poinçonnée pour pouvoir la visser à un châssis. Cette aile peut également être équipée d'organes de commande du circuit intégré hybride.

Pour diminuer la résistance thermique du contact entre l'aile 29 et le châssis, on laissera la partie correspondante de l'aile 29 libre de tout dépôt d'émail. De cette façon l'âme métallique du substrat peut servir aussi bien de plan de masse que de dissipateur thermique.

Suivant la même idée, il est possible de mettre à l'extrémité 28 du substrat un connecteur dont un plan de contact pourra être utilisé pour les connexions électriques et l'autre plan comme « connexion » thermique et liaison de masse.

Si l'on désire augmenter la surface de refroidissement d'un tel circuit, il faudra laisser vierge de tout élément électronique une partie de la plaque.

4

**Revendications**

1. Procédé de fabrication d'un circuit intégré hybride constitué par une association sur un support d'éléments passifs, tels que résistances et condensateurs déposés en couches minces ou épaisses, et d'éléments actifs, tels que diodes, transistors ou circuits intégrés monolithiques (25), réunis entre eux par un réseau d'interconnexion (24), caractérisé en ce qu'il comporte les opérations suivantes :

a) on prend une plaque (20) d'acier non oxydée de dimensions conformes au circuit à fabriquer ;

b) on prépare physiquement et chimiquement les surfaces de la plaque (20) d'acier de manière qu'elles soient aptes à accrocher par la suite une couche d'émail vitrifiable sur acier, principalement par nettoyage, puis nickelage ;

c) on masque complètement des zones de surface choisies sur la plaque par application locale d'une couche de « réserve » (21) constituée de matériaux organiques décomposables ou volatilisables par un traitement thermique convenable ;

d) on dépose sur les faces de la plaque et par-dessus les zones masquées une couche uniforme d'une composition d'émail (22) vitrifiable pour acier, par l'une au moins des techniques connues suivantes : peinture, trempé, projection, évaporation, électrophorèse, dépôt par flot ou sérigraphie ;

e) on sèche la couche d'émail (22) déposée par chauffage à une température gardant intact le matériau de la couche de « réserve » (21) ;

f) on retire les parties de la couche d'émail (22) séchée qui sont déposées sur la couche de « réserve » (21), par application de l'une au moins des techniques suivantes telles que l'application de vibrations, de chocs, de soufflage d'air, d'aspiration ou par un moyen de préhension ;

g) on soumet la plaque à un traitement thermique, susceptible de faire adhérer la couche d'émail (22) séchée et de former une couche diélectrique sur l'acier, ainsi que pour volatiliser ou brûler le matériau de la couche de « réserve » (21) sur les zones masquées et mettre celles-ci à nu ;

h) on revêt les zones de surface de plaque (20) nues d'une couche métallique (23) soudable et bonne conductrice d'électricité, ou de couches successives de compositions métalliques différentes, couches déposées selon au moins l'une des techniques connues suivantes : dépôt, chimique, électrolytique, sérigraphique ou par évaporation ou projection de métaux à travers un masque ;

i) on réalise le réseau d'interconnexion (24) sur la couche continue d'émail diélectrique (22) par au moins l'une des techniques de dépôts connus, telles que l'évaporation, la projection de métaux ou l'application sérigraphique d'encres ou pâtes conductrices, diélectriques, ou résistives appliquées à travers des masques et par cuisson subséquente ;

j) on fixe les éléments passifs et actifs ou les circuits intégrés monolithiques sur lesdites zones de surface de plaque préalablement métallisées par la couche métallique (28), en utilisant au moins l'une des techniques connues telles que : l'alliage, le brasage, le soudage avec apport ou non d'un métal ou d'un mélange eutectique, ou encore le collage avec une colle conductrice.

2. Procédé selon la revendication 1, caractérisé en ce que l'étape c) consiste à masquer des zones de surface choisies sur la plaque (20) par des caches métalliques ou en papier et en ce que ces caches sont retirés avant le traitement thermique g) destiné à cuire l'émail.

3. Procédé selon la revendication 1, caractérisé en ce que l'étape c) consiste à masquer des zones de surface choisies sur la plaque (20) par des vernis pelables qui sont enlevés avant le stade g).

4. Procédé selon l'une quelconque des revendications 1, 2 ou 3, caractérisé en ce que le procédé est appliqué sur une plaque d'acier préformée et poinçonnée.

5. Procédé selon l'une quelconque des revendications 1 à 4, caractérisé en ce qu'une extrémité émaillée de la plaque (20) est pourvue de conducteurs déposés par sérigraphie et d'un organe de connexion, mâle ou femelle, vissé à la plaque (20), et relié électriquement à ces conducteurs.

6. Procédé selon l'une quelconque des revendications 1 à 5, caractérisé en ce qu'une partie de la plaque (20) n'est pas émaillée afin de servir de contact électrique et thermique.

**Claims**

1. A process of manufacturing an integrated hybrid circuit constituted by the assembly, on a support, of passive components such as resistors and condensators deposited in the form of thin or thick layers, and active components such as diodes, transistors or monolithic integrated circuits (25), which are interconnected by an interconnecting network (24), characterized in that it comprises the steps of :

a) providing a non oxidated steel plate (20) having dimensions corresponding to the circuit to be manufactured ;

b) preparing physically and chemically the surfaces of the steel plate (20) in such a manner that they are adapted subsequently to retain a layer of enamel vitrifiable on steel, said step of preparing being carried out mainly by cleaning and then chromium plating ;

c) entirely masking selected surface areas on the plate by locally applying a « reserve » layer (21) constituted by decomposable or volatilizable organic material by means of a convenient thermal treatment ;

d) depositing onto the faces of the plate and over the masked surface areas a uniform layer of vitrifiable enamel composition (22) adapted to enamel steel, by at least one of the following known technological methods : painting, immersion, projection, evaporation, electrophorese, flooding or serigraphy ;

e) drying the enamel layer (22) which has been heat-deposited, by heating at a temperature which allows the material of the « reserve » layer (21) to be preserved ;

f) removing those portions of the dried enamel layer (22) which have been deposited onto the « reserve » layer (21), by means of at least one of the following technological methods : application of vibration, shock, air blowing, aspiration, or by using prehension means ;

g) submitting the plate to a thermal treatment adapted to cause the dried enamel layer (22) to adhere and to form a dielectric layer on the steel and also to cause the material constituting the « reserve » layer (21) to be volatilized or burned in the masked areas so as to expose the latter ;

h) covering the bare surface areas of the plate (20) with a weldable and electronically conductive metallic layer (23), or with successive layers having different metallic compositions, which layers are deposited according to at least one of the following known technological methods : depositing by a chemical, electrolytic, serigraphic process or by evaporation or projection of metals through a stencil ;

i) providing the interconnecting network (24) on the continuous dielectric enamel layer (22) by at least one of the known technological methods of depositing, such as evaporation, projection of metals or serigraphic application of conductive, dielectric or resistive inks or pastes applied through stencils, and by subsequently baking ;

j) fixing the passive and active components or the integrated monolithic circuits on said areas of the plate which have been previously metallized by the metallic layer (23) by means of at least one known technological method such as alloying, brazing, welding, with or without a build-up metal or eutectic mixture, or gluing with a conductive adhesive material.

2. Process according to claim 1, characterized in that step c) consists in masking the selected surface areas on the plate (20) by means of metallic or paper stencils, and in that said stencils are removed prior to carrying out the thermal treatment g) adapted to cause the enamel to be baked.

3. Process according to claim 1, characterized in that step c) consists in masking selected surface areas on the plate (20) by means of pealable varnishes which are removed prior to carrying out step g).

4. Process according to any of claims 1, 2 or 3, characterized in that said process is applied to a preformed punched steel plate.

5. Process according to any one of claims 1 to 4, characterized in that one enameled end of the plate (20) is provided with serigraphically deposited conductors and a male or female connecting element screwed onto the plate (20) and electrically connected to said conductors.

6. Process according to any one of claims 1 to 5, characterized in that a portion of the plate (20) is not enameled, so as to constitute an electric thermal contact.

**Ansprüche**

1. Verfahren zur Herstellung eines integrierten Hybrid-Stromkreises, bei dem passive Bauteile, wie in Form dünner oder dicker Schichten aufgebrachter Widerstände und Kondensatoren auf einer Unterlage mit aktiven Bauteilen, wie Dioden, Transistoren oder monolithischen integrierten Stromkreisen (25) vereinigt werden, die miteinander vermittels eines Verbindungsneztes (24) verbunden sind, gekennzeichnet durch folgende Verfahrensschritte :

a) man stellt eine nicht oxydierte Stahlplatte (20) mit dem herzustellenden Stromkreis entsprechenden Abmessungen bereit ;

b) man behandelt die Oberflächen der Stahlplatte (20) physikalisch und chemisch derart, dass sie danach im stande sind, eine auf Stahl verglasbare Emailschicht festzuhalten, insbesondere durch Reinigen und nachfolgendes Vernickeln ;

c) man deckt vorbestimmte Zonen der Plattenoberfläche durch örtliche Anbringung einer aus vermittels einer geeigneter Wärmebehandlung zersetzbaren oder sich verflüchtigenden organischen Stoffen bestehenden « Reserveschicht » (21) völlig ab ;

d) man bringt auf die Plattenoberflächen und auf die abgedeckten Zonen eine einheitliche Schicht (22) einer verglasbaren Emailzusammensetzung für Stahl an, unter Anwendung wenigstens eines der folgenden bekannten Verfahren : Aufstreichen, Tauchen, Projektion, Verdampfen, Elektrophorese, Aufbringen durch Befluten oder Serigraphie ;

e) man trocknet die aufgebrachte Emailschicht (22) durch Erhitzen auf eine Temperatur, bei welcher die Substanz der « Reserveschicht » (21) intakt bleibt ;

f) man entfernt diejenigen Teile der getrockneten Emailschicht (22), die auf der « Reserveschicht » (21) aufgebracht sind, unter Anwendung wenigstens eines der folgenden bekannten Verfahren : Aufbringen durch Vibration, Stoss, Luftblasverfahren, Ansaugen oder mit Hilfe eines Greifmittels ;

g) man unterwirft die Platte einer Wärmebehandlung, dank welcher die getrocknete Emailschicht (22) haftet und auf dem Stahl eine dielektrische Schicht bildet, wobei ferner das Material der « Reserveschicht » (21) in den abgedeckten Zonen zwecks Blanklegung derselben verflüchtig oder verbrannt wird ;

h) man bedeckt die blanken Oberflächenzonen der Platte (20) mit einer elektrisch leitenden, schweissbaren Metallschicht (25) bzw. mit nacheinander angeordneten Metallschichten verschiedener Zusammensetzung, unter Anwendung wenigstens eines der folgenden bekannten Verfahren : chemische, elektrolytische bzw. serigraphische Beschichtung oder Beschichtung durch Verdampfen oder Projection von Metallen durch eine Schablone hindurch ;

i) man stellt auf der kontimuierlichen dielektrischen Emailschicht (22) unter Anwendung wenigstens eines der folgenden bekannten Verfahren das Verbindungsnetz her : Verdampfen, Projektion von Metallen oder serigraphisches Aufbringen von leitfähigen, dielektrischen oder elektrisch widerstandsfähigen Anstrichen oder Pasten durch eine Schablone hindurch mit nachfolgendem Brennen ;

j) man befestigt auf den genannten zuvor mit der Metallschicht (23) beschichteten Platten-Oberflächenzonen die passiven und aktiven Bauteile, oder die integrierten monolithischen Stromkreise, unter Anwendung wenigstens eines der folgenden bekannten Verfahren : Legieren, Löten, Schweissen mit oder Zuschlag eines Metalls oder eines eutektischen Gemischs, oder Kleben vermittels eines leitfähigen Klebers.

2. Verfahren nach Anspruch 1, dadurch gekennzeichnet, dass der Verfahrensschritt c) darin besteht, die vorbestimmten Oberflächenzonen der Platte (20) vermittels aus Metall oder Papier bestehender Masken abzudecken, und dass man diese Masken vor der zwecks Brennen des Emails durchgeführten Wärmebehandlung g) entfernt.

3. Verfahren nach Anspruch 1, dadurch gekennzeichnet, dass der Verfahrensschritt c) darin besteht, die vorbestimmten Oberflächenzonen der Platte (20) mit abpellbaren Firnissenabzudecken, die vor der Durchführung des Verfahrensschrittes g) abgelöst werden.

4. Verfahren nach einem der Ansprüche 1, 2 oder 3, dadurch gekennzeichnet, dass das Verfahren auf eine vorgeformte und gestanzte Stahlplatte angewandt wird.

5. Verfahren nach einem der Ansprüche 1 bis 4, dadurch gekennzeichnet, dass ein emailliertes Ende der Platte (20) mit serigraphisch aufgebrachten Leitern und einem männlichen oder weiblichen, an der Platte angeschraubten und mit den genannten Leitern verbundenen Verbindungselement versehen wird.

6. Verfahren nach einem der Ansprüche 1 bis 5, dadurch gekennzeichnet, dass ein Teil der Platte (20) nicht emailliert wird, um einen elektrischen und thermischen Kontakt zu bilden.

Fig. 1

Fig. 2

Fig. 3

Fig. 4

Fig. 5

Fig. 6

Fig. 7

Fig.8

Fig.9

Fig.10

Fig.11

Fig.12

2